# FASCICULE DE BREVET EUROPEEN

(11) **EP 3 177 115 B1**
(45) Date de publication et mention de la délivrance du brevet: **09.05.2018**
(21) Numéro de dépôt: 16201056.5
(22) Date de dépôt: 29.11.2016
(51) Int. Cl.: H05K 1/02, H05K 7/14, H02K 5/00, H02K 11/33, H05K 1/18, H05K 3/20, H01L 23/34

(54) **ENSEMBLE D'UN MODULE ÉLECTRONIQUE DE PUISSANCE ET D'UN SUPPORT DE MODULE ÉLECTRONIQUE DE PUISSANCE, ARCHITECTURE ÉLECTRONIQUE LE COMPRENANT, CONVERTISSEUR DE TENSION ET MACHINE ÉLECTRIQUE LE COMPRENANT**
ANORDNUNG VON EINEM ELEKTRONISCHEN LEISTUNGSMODUL UND EINEM TRÄGER FÜR ELEKTRONISCHES LEISTUNGSMODUL, DIESE UMFASSENDE ELEKTRONISCHE ARCHITEKTUR, SPANNUNGSWANDLER UND ELEKTRISCHE MASCHINE
ASSEMBLY OF AN ELECTRONIC POWER MODULE AND A SUPPORT FOR AN ELECTRONIC POWER MODULE, ELECTRONIC ARCHITECTURE INCLUDING SAME, VOLTAGE CONVERTER AND ELECTRIC MACHINE COMPRISING SAME

(30) Priorité: 02.12.2015 FR 1561739
(43) Date de publication de la demande: 07.06.2017
(73) Titulaire: Valeo Systemes de Controle Moteur, 95800 Cergy Saint Christophe (FR)
(72) Inventeur: Tramet, Guillaume, 78360 Montesson (FR); Mas, Arnaud, 95000 Cergy (FR); Sacco, Ernesto, 95000 Cergy (FR)
(74) Mandataire: Novembre, Christophe Adelphe

(56) Documents cités:
- EP-A1- 2 525 634
- FR-A1- 2 967 846
- FR-A1- 3 020 727

## Description

L'invention a pour objet un ensemble d'un module électronique de puissance, notamment destiné à être intégré dans un convertisseur de tension et d'un support de module électronique de puissance.

L'invention concerne également une architecture électronique comprenant un tel ensemble et un convertisseur de tension destiné à être intégré dans une machine électrique. Un autre objet de l'invention concerne une machine électrique comprenant un tel convertisseur de tension.
Les documents FR 3 020 727 A1, EP 2 525 634 A1 et FR 2 967 846 décrivent des modules électroniques de puissance selon l'art antérieur. Usuellement, un module électronique de puissance, destiné à alimenter une machine électrique, nécessite un boitier permettant l'isolation électrique du module électronique et la connexion électrique du module électronique de puissance à des éléments électriques de la machine électrique. De tels modules électroniques nécessitent en général des lignes de production spécifiques, et par conséquent ont des coûts de production élevés.

La présente invention vise à remédier à ces inconvénients en proposant un module électronique de puissance compact et fabriqué sur des lignes de fabrication standards, telles que les lignes de production utilisées pour la production de modules électroniques en technologie « DBC » (de l'anglais *Direct Bounded Copper*)*.*

A cet effet, l'invention a pour objet un ensemble d'un module électronique de puissance et d'un support de module électronique de puissance tel que défini dans la revendication 1. Avantageusement, le module électronique de puissance selon l'invention peut être fabriqué sur des lignes de production standard, utilisant des procédés tels que la sérigraphie, le dépôt de composants en surface (« CMS »), ou la refusion, utilisées pour la production de modules électroniques en technologie « DBC », ce qui réduit les coûts de production d'un tel module électronique. En outre, un tel module électronique de puissance permet une simplification des procédés d'assemblage et de fabrication.

Le module électronique de puissance selon l'invention peut également comprendre une ou plusieurs des caractéristiques suivantes, considérées individuellement ou selon toutes les combinaisons possibles :
- le substrat plan est dépourvu de parois latérales s'étendant depuis le substrat plan sensiblement perpendiculairement à la face supérieure du substrat plan ;
- le substrat plan comprend une partie supérieure comprenant la au moins une trace de puissance et une partie inférieure comprenant au moins une cavité ouverte, le fond de la cavité ouverte étant formé au moins en partie par au moins une portion de la au moins une trace de puissance ;
- la partie inférieure et la partie supérieure du substrat plan sont formées en continuité de matière.

L'invention se rapporte à un ensemble d'un module électronique de puissance et d'un support de module électronique de puissance, notamment destiné à être intégré dans un convertisseur de tension, comprenant:
- un module électronique de puissance selon l'invention, le module électronique comprenant une partie inférieure comprenant au moins une cavité ouverte ; et
- un support de module électronique de puissance comprenant une cavité de réception du module électronique de puissance, la cavité de réception comprenant un fond à partir duquel s'étend de façon sensiblement perpendiculaire au moins une protubérance du support; et
dans lequel la ou chaque cavité ouverte du module électronique de puissance est destinée à recevoir au moins une protubérance.

Avantageusement, l'ensemble selon l'invention permet une dissipation thermique efficace de la chaleur générée par le module électronique de puissance, et par conséquent permet de diminuer l'usure des composants du module électronique de puissance.

L'ensemble selon l'invention peut également comprendre une ou plusieurs des caractéristiques suivantes, considérées individuellement ou selon toutes les combinaisons possibles :
- le fond de la ou chaque cavité ouverte du module électronique est formé au moins en partie par au moins une portion de la au moins une trace de puissance ;
- le module électronique de puissance est supporté mécaniquement par la au moins une protubérance ;
- la cavité de réception est destinée à recevoir un matériau isolant, de sorte que le module électronique de puissance est noyé dans le matériau isolant.

L'invention a également pour objet une architecture électronique, notamment destinée à être intégrée dans un convertisseur de tension, comprenant une pluralité de modules électroniques de puissance et un support commun aux modules électroniques de puissance de sorte que chaque module électronique de puissance et le support forme un ensemble selon l'invention.

Avantageusement, l'architecture électronique selon l'invention permet une dissipation thermique efficace de la chaleur générée par la pluralité de modules électroniques de puissance, et ainsi une augmentation de la durée de vie des composants des modules électroniques de puissance.

En outre, une pluralité de modules électroniques de puissance associée à un support commun permet une réduction des coûts et du temps de production.

L'invention se rapporte également à un convertisseur de tension notamment destiné à alimenter une machine électrique, comprenant au moins une architecture électronique selon l'invention ou un ensemble selon l'invention.

Selon un mode de réalisation de l'invention, le convertisseur de tension peut comprendre un dissipateur thermique formant le support du ou des modules électroniques de puissance.

L'invention concerne également une machine électrique pour véhicule automobile comprenant au moins un convertisseur de tension selon l'invention intégré avec la dite machine électrique. Par exemple, la machine électrique est un démarreur, un alterno-démarreur ou une autre machine électrique embarquée dans le véhicule.

D'autres caractéristiques et avantages de la présente invention apparaitront à la lecture de la description et des figures suivantes :
- la figures 1 représente une vue d'une face supérieure d'un substrat plan d'un module électronique de puissance selon un mode de réalisation de l'invention,
- la figure 2 représente une vue d'une face inférieure du substrat plan du module électronique de puissance de la figure 1 selon un mode de réalisation de l'invention,
- la figure 3 représente une vue éclatée selon un mode de réalisation d'un ensemble d'un module électronique de puissance et d'un support de module électronique selon l'invention,
- la figure 4 représente une vue en section d'un ensemble d'un module électronique de puissance et d'un support de module électronique selon un mode de réalisation de l'invention,
- la figure 5 est une vue éclatée selon un mode de réalisation d'un convertisseur de tension selon l'invention, et
- la figure 6 représente une vue en coupe selon un mode de réalisation d'un convertisseur de tension assemblé de la figure 4 selon l'invention.

Il est à noter que ces dessins n'ont d'autre but que d'illustrer le texte de la description et ne constituent en aucune sorte une limitation de la portée de l'invention.

Sur les différentes figures, les éléments analogues sont désignés par des références identiques.

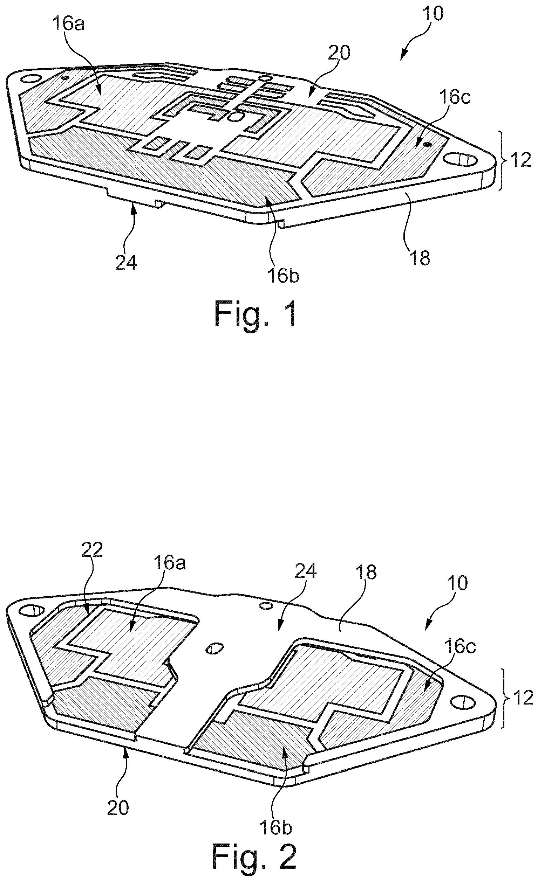

L'invention se rapporte à un module électronique de puissance, notamment destiné à être intégré dans un convertisseur de tension. Le convertisseur de tension est notamment destiné à transmettre un courant électrique d'une source d'énergie électrique à la machine électrique dans laquelle il est intégré. En particulier, les figures 1 et 2 représentent respectivement une face supérieure 20 et une face inférieure 24 d'un substrat plan 12 d'un module électronique de puissance 10 selon l'invention.

Le module électronique de puissance 10 comprend un substrat plan 12, le substrat plan 12 comprenant au moins une trace de puissance surmoulée au moins en partie de matériau isolant électriquement, de préférence de matériau plastique. En particulier, sur la figure 1, le substrat plan 12 du module électronique de puissance comprend trois traces de puissance 16a, 16b, 16c surmoulées au moins en partie de matériau isolant électriquement. Une trace de puissance est une trace conductrice électriquement, notamment métallique, par exemple une piste de cuivre. Une trace de puissance est notamment configurée pour supporter un courant électrique destiné à circuler dans la machine électrique.

Chaque trace de puissance 16a, 16b, 16c comprend au moins une portion dépourvue de surmoulage, notamment destinée à être connectée électriquement à des éléments électriques extérieurs au module électronique de puissance 10 tels que précisés par la suite.

L'épaisseur du substrat plan 12 peut être comprise par exemple entre 0,5 mm et 5 mm, et dépend, en général de l'épaisseur des traces de puissance. Par exemple, l'épaisseur des traces de puissance peut être comprise entre 600 microns et 2000 microns.

De préférence, le substrat plan 12 est dépourvu de parois latérales s'étendant depuis le substrat plan 12 et notamment depuis la face supérieure 20 du substrat plan 12. Avantageusement, cela permet une isolation simultanée d'une pluralité de modules électroniques disposés sur un support commun, mais également une simplification du procédé de fabrication, notamment pour la refusion, ainsi qu'un gain de place au sein du convertisseur de tension.

Selon un mode de réalisation préféré, le substrat plan 12 comprend une partie supérieure 70 et une partie inférieure 72, avantageusement formées en continuité de matière. En particulier, la partie supérieure 70, notamment visible sur la figure 1, comprend au moins une trace de puissance, et la partie inférieure 72, notamment visible sur la figure 2, comprend au moins une cavité ouverte 22. Le fond de la cavité ouverte 22 est de préférence formé au moins en partie par au moins une portion d'une trace de puissance. Le surmoulage 18 des traces de puissance 16a, 16b, 16c forme au moins en partie le bord des cavités ouvertes 22. En particulier, comme représenté sur la figure 2, le module électronique de puissance 10 comprend deux cavités ouvertes 22. Les cavités ouvertes permettent notamment une dissipation thermique, et seront détaillées par la suite.

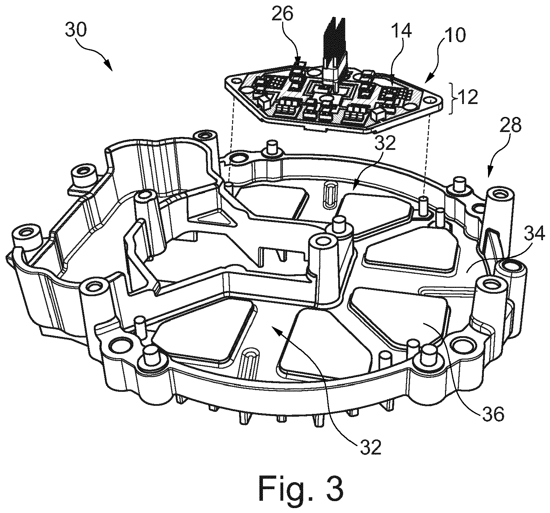

Comme représenté sur la figure 3, le module électronique de puissance 10 comprend au moins un composant électronique 14, agencé sur la face supérieure 20 du substrat plan 12, de sorte à être connecté électriquement à une des traces de puissance.

Le module électronique de puissance 10 peut également comprendre au moins un élément de connexion extérieure 26, disposé sur la même face du substrat plan 12 que le composant électronique 14. L'élément de connexion extérieure 26 peut comprendre une languette en matériau conducteur pliée en forme de « Z » de sorte à comprendre au moins une face plane inférieure en contact avec le substrat plan 12 et une face plane supérieure destinée à connecter électriquement une trace de puissance à au moins un élément électrique extérieur au module électronique de puissance 10. Par exemple, un élément de connexion extérieure 26 peut être destiné à connecter électriquement la première trace de puissance 16a à une phase (ϕ) de la machine électrique, ou la deuxième trace de puissance 16b à un pôle de polarité positif (B+) d'une source d'énergie électrique, ou la troisième trace de puissance 16c à un pôle de polarité négatif (B-) ou à la masse d'une source d'énergie électrique.

De préférence, le montage des éléments de connexion extérieure 26 et des composants électroniques 14 sur le substrat plan 12 est obtenu par dépôt de pâte à braser puis par disposition des composants électroniques 14 et des éléments de connexion extérieure 26 en surface du substrat plan 12 du module électronique de puissance (« CMS »). Le matériau isolant électriquement du substrat plan 12 du module électronique 10 est avantageusement en matériau plastique haute température, de sorte à ne pas être altéré lors du passage du module électronique 10 au four pour la refusion des composants. Un tel procédé de fabrication des modules électroniques permet de diminuer le nombre de liaisons entre les composants du module électronique 10, notamment les composants électroniques 14 et les éléments de connexion extérieure 26, et ainsi de simplifier le procédé de fabrication et d'assemblage des modules électroniques. De plus, le montage des composants électroniques 14 et des éléments de connexion extérieure 26 directement sur le substrat plan permet un gain de place au sein du convertisseur de tension.

En particulier, les composants électroniques 14 et/ou les éléments de connexion extérieure 26 sont montés sur une trace de puissance 16a, 16b, 16c. Notamment, un contact électrique est réalisé avec la trace de puissance 16a, 16b, 16c par la face du composant électronique 14 ou de l'élément de connexion 26 qui est en contact avec la trace de puissance 16a, 16b, 16c. En outre, le composant électronique 14 peut être en contact électrique avec d'autres composants électroniques 14, ou une autre trace de puissance que celle sur laquelle elle est montée, notamment par des fils de connexions (encore appelés « bonding » en anglais).

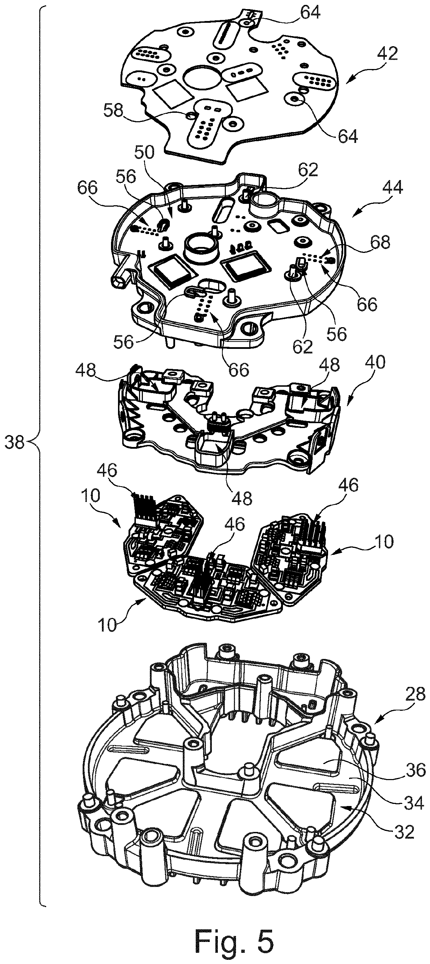

Le module électronique de puissance tel que décrit précédemment est destiné à être reçu par un support 28 de module électronique. En particulier, un ensemble 30 d'un module électronique de puissance 10 et d'un support 28 de module électronique selon l'invention est représenté sur les figures 3 et 4. L'ensemble 30 est notamment destiné à être intégré dans un convertisseur de tension.

Le support 28 de module électronique de puissance comprend une cavité de réception 32 du module électronique de puissance 10. En particulier, comme illustré sur la figure 3, le support 28 de module de puissance comprend trois cavités de réception 32, chaque cavité de réception 32 étant destinée à recevoir un module électronique de puissance 10.

Le support 28 permet une conduction thermique et électrique, notamment pour la reprise de la masse et la dissipation de la chaleur. La cavité de réception comprend un fond 34 à partir duquel s'étend de façon sensiblement perpendiculaire au moins une protubérance 36 du support 28. La ou chaque cavité ouverte 22 du module électronique de puissance 10 est destinée à recevoir au moins une protubérance 36.

La ou chaque protubérance 36 est destinée à être recouverte d'un matériau C conducteur thermiquement et isolant électriquement, notamment visible sur la figure 4. Par exemple, le matériau C conducteur thermiquement est avantageusement une graisse thermique.

Le fond de chaque cavité ouverte 22 du module électronique 10 est formé au moins en partie par une portion d'une trace de puissance. Par exemple, comme illustré sur la figure 4, le fond de chaque cavité ouverte 22 est formé par deux portions de traces de puissances 16b, 16c et par une portion de surmoulage. Bien entendu, le fond des cavités ouvertes 22 peut être formé par une seule ou une pluralité de traces de puissances ou portions de traces de puissance. De plus, le fond de chaque cavité 22 est en contact avec la ou chaque protubérance 36. En particulier, comme visible sur la figure 4, le module électronique de puissance 10 est supporté mécaniquement par la au moins une protubérance 36. Autrement dit, le module électronique de puissance 10 est destiné à être en appui sur les protubérances 36 du support 28. Un espace entre le module électronique de puissance 10 et le fond 34 de la cavité de réception 30 du support 28, visible sur la figure 4, en résulte pour l'isolation électrique et thermique du module électronique de puissance 10.

Avantageusement, la cavité de réception 32 du support 28 est destinée être remplie d'un matériau isolant A, notamment visible sur la figure 4, de sorte que le module électronique de puissance 10 est noyé dans le matériau isolant A. Le matériau isolant peut être un gel isolant, par exemple un gel en silicone, ou une résine isolante, par exemple une résine époxy.

En particulier, cette configuration permet une isolation efficace des modules électroniques 10. De façon avantageuse, le support 28 de module puissance est un dissipateur de chaleur, aussi nommé dissipateur thermique. Les modules de puissance 10 sont fixés au dissipateur thermique afin de permettre le transfert thermique entre les modules de puissance 10 et un circuit de refroidissement (non représenté), afin de dissiper la chaleur générée par les modules électroniques 10.

De préférence, comme illustré sur la figure 4, une extrémité de l'élément de connexion extérieure 26 destinée à connecter électriquement une trace de puissance à au moins un élément électrique extérieur au module électronique de puissance 10 dépasse de la couche de matériau A isolant recouvrant le composant électronique 14.

De façon avantageuse, le composant électronique 14 est recouvert d'une couche de matériau isolant A. En particulier, la couche de matériau isolant recouvrant le composant électronique 14 a une épaisseur supérieure d'au moins 1 mm à une extrémité du composant électronique 14 opposée à une extrémité du composant électronique 14 en contact avec le substrat plan 12.

En outre, la cavité de réception 32 des modules électroniques 10 peut comprendre des éléments de positionnement (non représentés) destinés à positionner les modules électroniques 10 sur le support 28 dans une position prédéterminée. Ces éléments de positionnement permettent de faciliter et garantir un positionnement correct et rapide des modules électroniques 10 sur le support 28.

Une pluralité de modules électroniques de puissance 10 et un support 28 commun aux modules électroniques de puissance 10 tels que décrits précédemment sont notamment destinés à être intégrés dans un convertisseur de tension.

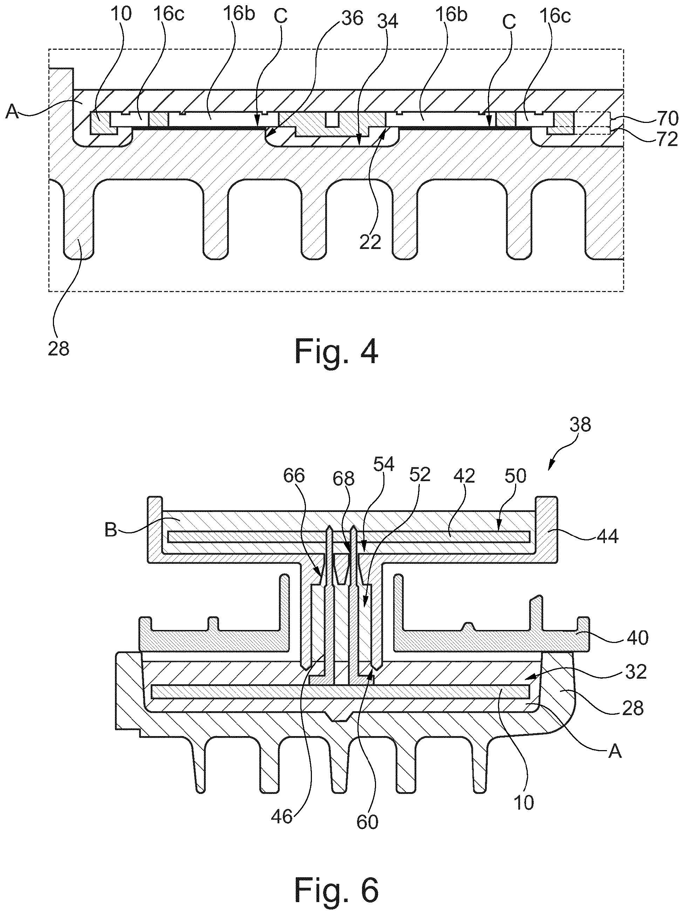

En particulier, la figure 5 représente une vue éclatée d'un tel convertisseur de tension 38, destiné à être intégré dans une machine électrique, comprenant une architecture électronique, c'est-à-dire des modules électroniques de puissance 10, dans cet exemple au nombre de trois, et un support 28 des modules électroniques tels que décrits précédemment. Le convertisseur de tension 38 comprend de préférence un dissipateur thermique formant le support des modules électroniques de puissance.

Le convertisseur de tension 38 peut également comprendre un connecteur électrique 40, une carte électronique de contrôle 42, et un support 44 de carte électronique.

Avantageusement, le convertisseur de tension 38 est un convertisseur alternatif-continu. De préférence, le convertisseur de tension 38 est intégré au carter de la machine électrique, notamment en positionnant le support 28 sur une extrémité du carter de la machine électrique.

La carte électronique de contrôle 42 est notamment destinée à contrôler les modules électroniques de puissance 10. En particulier, la carte électronique 42 est destinée à être connectée électriquement avec les modules électroniques de puissance 10 via au moins un élément de connexion électrique 46.

Le connecteur électrique 40 est agencé entre le support 28 des modules électroniques de puissance et le support 44 de la carte électronique. Le connecteur électrique 40 est configuré pour connecter électriquement les modules électroniques 10 à au moins un des éléments électriques (phase ϕ) de la machine électrique et/ou à au moins un des éléments électriques (B⁺, B⁻) d'une source d'énergie électrique. Les éléments électriques de la machine électrique sont, par exemple, des phases ϕ. Les éléments électriques de la source d'énergie électrique sont par exemple une borne continue positive B⁺, une borne continue négative B⁻ ou la masse. Il y a de préférence un module électronique de puissance 10 par phase ϕ. En outre, comme représenté sur la figure 5, le connecteur électrique 40 comprend des orifices 48 agencés pour autoriser l'accès des éléments de connexion électrique 46 des modules électroniques 10 avec la carte électronique de contrôle 42.

Le support 44 de la carte électronique de contrôle est agencé entre les modules électroniques de puissance 10 et la carte électronique de contrôle 42. Le support 44 de la carte électronique de contrôle est de préférence en matière isolante, par exemple moulé en matière plastique. Le support 44 comprend une cavité ouverte 50 ayant un fond sur lequel la carte électronique 42 est destinée à être reçue.

Le support 44 comprend également au moins une colonne creuse 52 dans laquelle le au moins un élément de connexion électrique 46 de la carte électronique 42 avec les modules électroniques 10 est destiné à être inséré. La colonne creuse 52, notamment visible sur la figure 6, s'étend depuis la cavité ouverte 50 et est configurée pour communiquer avec la cavité ouverte 50 à une première extrémité 54 de la colonne creuse 52. En particulier, le support 44 de la carte électronique peut comprendre une pluralité de colonnes creuses, chaque colonne creuse étant destinée à recevoir les éléments de connexion électrique 46 de chaque module électronique 10 avec la carte électronique de contrôle 42. La cavité ouverte 50 est destinée à être remplie d'un matériau isolant de sorte que la carte électronique de contrôle 42 est noyée dans le matériau isolant. Par exemple, comme représenté sur la figure 6, la carte électronique est noyée dans un matériau isolant B. La carte électronique de contrôle 42 est ainsi isolée de manière efficace.

Avantageusement, le support 44 de carte électronique de contrôle peut comprendre un élément de remplissage 56 de la colonne creuse 32. L'élément de remplissage 56, également appelé canal de remplissage, peut avoir une forme générale de rampe, préférentiellement une forme hélicoïdale.

La carte électronique de contrôle 42 peut comprendre avantageusement un orifice 58 agencé en vis-à-vis de l'extrémité du canal 56 communiquant avec le fond de la cavité ouverte 50. L'orifice 58 de la carte électronique 42 permet le remplissage de la colonne creuse 52 de matériau isolant B par l'intermédiaire du canal 56.

Une extrémité de l'élément de remplissage 58 communique avec le fond de la cavité ouverte 50 et une autre extrémité de l'élément de remplissage 58 communique avec une paroi latérale de la colonne creuse 52. De préférence, une seconde extrémité 60 de la colonne creuse 52 est en contact avec le matériau isolant dans lequel le module électronique 10 est noyé. Cette configuration permet de garantir le remplissage de la colonne creuse 52 de matériau isolant, et ainsi d'assurer une isolation efficace des éléments de connexion électrique 46.

De préférence, comme illustré sur la figure 6, une seconde extrémité 60 de la colonne creuse 52 est en contact avec le matériau isolant A dans lequel le module électronique 10 est noyé. Cette configuration permet de garantir le remplissage de la colonne creuse 52 de matériau isolant B, et ainsi d'assurer une isolation efficace à la poussière, aux liquides, aux gaz ou encore à l'humidité des éléments de connexion électrique 46. Le matériau isolant permet ainsi de supprimer tout risque de court-circuit possible au niveau de l'interconnexion de la carte électronique 42 avec les modules électroniques de puissance 10.

En particulier, la carte électronique de contrôle 42 et les modules électroniques de puissance 10 peuvent être isolés avec des matériaux isolants A, B identiques ou différents, de préférence un matériau isolant identique, notamment un gel isolant.

L'interface entre le matériau isolant A du module électronique de puissance 10 et le matériau isolant B de la carte électronique de contrôle 42 est notamment située à l'intérieur de la colonne creuse 52, à proximité de la seconde extrémité 60 de la colonne creuse 52.

En outre, l'espace compris entre la carte électronique 42 et le module de puissance 10 et entourant la colonne creuse 52 est dépourvu de matière, notamment de matériau isolant. L'espace libre de matière, notamment de matériau isolant, a, entre autres, pour effet de laisser un espace libre pour la circulation d'air, permettant ainsi un refroidissement par convection. De plus, cette configuration permet de diminuer les coûts de production du convertisseur de tension 36, grâce notamment à un gain en matériau isolant. Cet espace libre de matière reçoit au moins en partie le connecteur électrique 40.

En outre, le fond de la cavité ouverte 50 comprend de préférence des éléments de positionnement 62 destinés à positionner la carte électronique 42 sur le support 44 dans une position prédéterminée. Autrement dit, les éléments de positionnement 62 disposés sur le support 44 de la carte électronique sont destinés à coopérer avec des éléments de positionnement complémentaires 64 de la carte électronique 42. Par exemple, sur la figure 5, six éléments de positionnement 62 sont représentés, comprenant chacun un ergot faisant saillie depuis le fond de la cavité ouverte 50, de façon perpendiculaire au fond. Les éléments de positionnement 62 peuvent être de forme cylindrique comme représenté sur la figure 5. Les six éléments de positionnement complémentaires 64 de la carte électronique sont des orifices de positionnement présentant de préférence une section de forme et de dimensions complémentaires à la forme et aux dimensions des éléments de positionnement 62. Par exemple, comme illustré sur la figure 5, les éléments de positionnement complémentaires 64 présentent une section circulaire. Ces éléments de positionnement 62 permettent de positionner correctement et rapidement la carte électronique 42 sur le support 44, et ainsi de permettre une connexion électrique efficace de la carte électronique 42 avec les modules électroniques de puissance 10.

De plus, le fond de la cavité ouverte 50 comprend avantageusement des éléments de guidage 66 du au moins un élément de connexion électrique 46 agencés à la première extrémité 54 de la colonne creuse 52 et destinés à guider le au moins un élément de connexion électrique 46 vers la carte électronique 42. Par exemple, sur la figure 5, le fond de la cavité ouverte 50 comprend trois groupes d'éléments de guidage 66. Les éléments de guidage 66 comprennent des orifices de guidage 68, avantageusement un orifice de guidage 68 par élément de connexion électrique 46. Les orifices de guidage 68 permettent de recentrer les éléments de connexion électrique 46 en vue de la connexion électrique du module électronique 10 avec la carte électronique 42 et ainsi de connecter correctement le module électronique 10 avec la carte électronique 42. De préférence, afin de permettre un meilleur recentrage des éléments de connexion électrique 46, la section des orifices de guidage 68 en regard du module électronique 10 est plus grande que la section des orifices de guidage 68 en regard de la carte électronique 42. Par exemple, sur la figure 6, les deux éléments de guidage 66 présentent une section circulaire et comportent une portion tronconique suivie d'une portion cylindrique.

Le module électronique de puissance a été décrit dans le cadre d'un convertisseur de tension destiné à être intégré dans une machine électrique qu'il alimente. La machine électrique est notamment destinée à être embarquée dans un véhicule automobile pour permettre un démarrage d'un moteur thermique du véhicule et/ou produire de l'énergie électrique à partir du moteur thermique du véhicule. Notamment, le convertisseur de tension est rapporté sur un boîtier de la machine, par exemple par vissage dans des trous du convertisseur de tension. Bien entendu, l'invention n'est nullement limitée au mode de réalisation décrit et illustré, qui n'a été donné qu'à titre d'exemple. Au contraire, d'autres applications du module électronique de puissance conforme à l'invention sont également possibles sans sortir du cadre de l'invention. En particulier, le convertisseur de tension pourrait être indépendant de la machine électrique, par exemple en étant monté sur un support autre que la machine électrique.

## Revendications

1. Ensemble (30) d'un module électronique de puissance (10) et d'un support (28) de module électronique de puissance, notamment destiné à être intégré dans un convertisseur de tension (38), comprenant:
- un module électronique de puissance (10) notamment destiné à être intégré dans un convertisseur de tension (38), le module électronique de puissance (10) comprenant un substrat plan (12) comprenant au moins une trace de puissance (16a, 16b, 16c) surmoulée au moins en partie de matériau isolant électriquement, une face supérieure (20) destinée à recevoir au moins un composant électronique (14) de manière à être connecté électriquement à la au moins une trace de puissance (16a, 16b, 16c), ledit module électronique de puissance (10) comprenant une partie inférieure (72) comprenant au moins une cavité ouverte (22) ; et
- un support (28) de module électronique de puissance comprenant une cavité de réception (32) du module électronique de puissance (10), la cavité de réception (32) comprenant un fond à partir duquel s'étend, de façon sensiblement perpendiculaire, au moins une protubérance (36) du support (28) ; et
dans lequel la ou chaque cavité ouverte (22) du module électronique de puissance (10) est destinée à recevoir au moins une protubérance (36).

2. Ensemble (30) selon la revendication 1, dans lequel le substrat plan (12) est dépourvu de parois latérales s'étendant depuis le substrat plan (12), notamment depuis la face supérieure (20) du substrat plan (12).

3. Ensemble (30) selon la revendication 1 ou 2, dans lequel le fond de la ou chaque cavité ouverte (22) du module électronique (10) est formé au moins en partie par au moins une portion de la au moins une trace de puissance (16a, 16b, 16c).

4. Ensemble (30) selon la revendication 3, dans lequel le substrat plan (12) comprend une partie supérieure (70) comprenant la au moins une trace de puissance (16a, 16b, 16c).

5. Ensemble (30) selon la revendication 4, dans lequel la partie inférieure (72) et la partie supérieure (70) du substrat plan (12) sont formées en continuité de matière.

6. Ensemble (30) selon l'une des revendications précédentes, dans lequel le module électronique de puissance (10) est supporté mécaniquement par la au moins une protubérance (36).

7. Ensemble (30) selon l'une quelconque des revendications précédentes, dans lequel la cavité de réception (32) est destinée à recevoir un matériau isolant (A), de sorte que le module électronique de puissance (10) est noyé dans le matériau isolant (A).

8. Architecture électronique, notamment destinée à être intégrée dans un convertisseur de tension (38), comprenant une pluralité de modules électroniques de puissance (10) et un support (28) commun aux modules électroniques de puissance (10) de sorte que chaque module électronique de puissance (10) et le support (28) forme un ensemble (30) selon l'une quelconque des revendications 1 à 7.

9. Convertisseur de tension (38) notamment destiné à alimenter une machine électrique, comprenant au moins une architecture électronique selon la revendication 8 ou un ensemble selon l'une des revendications 1 à 7.

10. Convertisseur de tension (38) selon la revendication 9, comprenant un dissipateur thermique formant le support (28) du ou des modules électroniques de puissance.

11. Machine électrique pour véhicule automobile comprenant au moins un convertisseur de tension (38) selon la revendication 9 ou 10 intégré avec la dite machine électrique.

## Patentansprüche

1. Anordnung (30) aus einem elektronischen Leistungsmodul (10) und einem Träger (28) für ein elektronisches Leistungsmodul, die insbesondere dazu bestimmt ist, in einen Spannungswandler (38) integriert zu werden, umfassend:
- ein elektronisches Leistungsmodul (10), das insbesondere dazu bestimmt ist, in einen Spannungswandler (38) integriert zu werden, wobei das elektronische Leistungsmodul (10) ein ebenes Substrat (12) umfasst, das wenigstens eine Leistungsleiterbahn (16a, 16b, 16c), die wenigstens teilweise mit elektrisch isolierendem Material umspritzt ist, und eine Oberseite (20), die dazu bestimmt ist, wenigstens eine elektronische Komponente (14) aufzunehmen, so dass sie mit der wenigstens einen Leistungsleiterbahn (16a, 16b, 16c) elektrisch verbunden ist, umfasst, wobei das elektronische Leistungsmodul (10) einen unteren Teil (72) umfasst, der wenigstens einen offenen Hohlraum (22) umfasst; und
- einen Träger (28) für ein elektronisches Leistungsmodul, welcher eine Vertiefung zur Aufnahme (32) des elektronischen Leistungsmoduls (10) umfasst, wobei die Aufnahmevertiefung (32) einen Boden umfasst, von dem aus sich wenigstens ein Vorsprung (36) des Trägers (28) im Wesentlichen senkrecht erstreckt; und
wobei der offene Hohlraum oder die offenen Hohlräume (22) des elektronischen Leistungsmoduls (10) dazu bestimmt ist (sind), wenigstens einen Vorsprung (36) aufzunehmen.

2. Anordnung (30) nach Anspruch 1, wobei das ebene Substrat (12) nicht mit seitlichen Wänden versehen ist, die sich von dem ebenen Substrat (12), insbesondere von der Oberseite (20) des ebenen Substrats (12) aus erstrecken.

3. Anordnung (30) nach Anspruch 1 oder 2, wobei der Boden des offenen Hohlraums oder der offenen Hohlräume (22) des elektronischen Moduls (10) wenigstens teilweise von wenigstens einem Abschnitt der wenigstens einen Leistungsleiterbahn (16a, 16b, 16c) gebildet wird.

4. Anordnung (30) nach Anspruch 3, wobei das ebene Substrat (12) einen oberen Teil (70) umfasst, der die wenigstens eine Leistungsleiterbahn (16a, 16b, 16c) umfasst.

5. Anordnung (30) nach Anspruch 4, wobei der untere Teil (72) und der obere Teil (70) des ebenen Substrats (12) stoffschlüssig miteinander verbunden sind.

6. Anordnung (30) nach einem der vorhergehenden Ansprüche, wobei das elektronische Leistungsmodul (10) durch den wenigstens einen Vorsprung (36) mechanisch abgestützt wird.

7. Anordnung (30) nach einem der vorhergehenden Ansprüche, wobei die Aufnahmevertiefung (32) dazu bestimmt ist, ein Isoliermaterial (A) aufzunehmen, derart, dass das elektronische Leistungsmodul (10) in das Isoliermaterial (A) eingebettet ist.

8. Elektronische Architektur, die insbesondere dazu bestimmt ist, in einen Spannungswandler (38) integriert zu werden, und mehrere elektronische Leistungsmodule (10) und einen Träger (28), der den elektronischen Leistungsmodulen (10) gemeinsam ist, umfasst, derart, dass jedes elektronische Leistungsmodul (10) und der Träger (28) eine Anordnung (30) nach einem der Ansprüche 1 bis 7 bilden.

9. Spannungswandler (38), der insbesondere dazu bestimmt ist, eine elektrische Maschine zu versorgen, und wenigstens eine elektronische Architektur nach Anspruch 8 oder eine Anordnung nach einem der Ansprüche 1 bis 7 umfasst.

10. Spannungswandler (38) nach Anspruch 9, welcher einen Kühlkörper umfasst, der den Träger (28) des oder der elektronischen Leistungsmodule bildet.

11. Elektrische Maschine für ein Kraftfahrzeug, welche wenigstens einen Spannungswandler (38) nach Anspruch 9 oder 10 umfasst, der mit der elektrischen Maschine integriert ist.

## Claims

1. Assembly (30) of a power electronic module (10) and of a electric power electronic module support (28), intended in particular to be incorporated in a voltage converter (38), comprising:
- a power electronic module (10) intended in particular to be incorporated in a voltage converter (38), the power electronic module (10) comprising a planar substrate (12) comprising at least one power trace (16a, 16b, 16c) overmoulded at least partly with electrically insulating material, a top face (20) intended to receive at least one electronic component (14) so as to be connected electrically to the at least one power trace (16a, 16b, 16c), said power electronic module (10) comprising a bottom part (72) comprising at least one open cavity (22); and
- a power electronic module support (28) comprising a receiving cavity (32) for the power electronic module (10), the receiving cavity (32) comprising a bottom from which extends, substantially at right angles, at least one protuberance (36) of the support (28); and
in which the or each open cavity (22) of the power electronic module (10) is intended to receive at least one protuberance (36).

2. Assembly (30) according to Claim 1, in which the planar substrate (12) has no lateral walls extending from the planar substrate (12), in particular from the top face (20) of the planar substrate (12).

3. Assembly (30) according to Claim 1 or 2, in which the bottom of the or each open cavity (22) of the electronic module (10) is formed at least partly by at least one portion of the at least one power trace (16a, 16b, 16c).

4. Assembly (30) according to Claim 3, in which the planar substrate (12) comprises a top part (70) comprising the at least one power trace (16a, 16b, 16c).

5. Assembly (30) according to Claim 4, in which the bottom part (72) and the top part (70) of the planar substrate (12) are formed by continuity of material.

6. Assembly (30) according to any one of the preceding claims, in which the power electronic module (10) is supported mechanically by the at least one protuberance (36).

7. Assembly (30) according to any one of the preceding claims, in which the receiving cavity (32) is intended to receive an insulating material (A), such that the power electronic module (10) is embedded in the insulating material (A).

8. Electronic architecture, intended in particular to be incorporated in a voltage converter (38), comprising a plurality of power electronic modules (10) and a support (28) common to the power electronic modules (10) such that each power electronic module (10) and the support (28) forms an assembly (30) according to any one of Claims 1 to 7.

9. Voltage converter (38) intended in particular to power an electric machine, comprising at least an electronic architecture according to Claim 8 or an assembly according to any one of Claims 1 to 7.

10. Voltage converter (38) according to Claim 9, comprising a heat sink forming the support (28) of the power electronic module or modules.

11. Electric machine for a motor vehicle comprising at least one voltage converter (38) according to Claim 9 or 10 incorporated with said electric machine.
